# EUROPÄISCHE PATENTSCHRIFT

(11) **EP 0 396 802 B1**
(45) Veröffentlichungstag und Bekanntmachung des Hinweises auf die Patenterteilung: **22.10.1997**
(21) Anmeldenummer: 89108511.0
(22) Anmeldetag: 11.05.1989
(51) Int. Cl.: H01L 29/735, H01L 21/331

(54) **Verfahren zur Herstellung einer integrierten Schaltungsstruktur mit einem lateralen Bipolartransistor**
Method of making an integrated circuit structure having a lateral bipolar transistor
Méthode de fabrication d'un circuit intégré comprenant un transistor bipolaire latéral

(43) Veröffentlichungstag der Anmeldung: 14.11.1990
(73) Patentinhaber: SIEMENS AKTIENGESELLSCHAFT, 80333 München (DE)
(72) Erfinder: Treitinger, Ludwig, Dr., D-8000 München 90 (DE); Bertagnolli, Emmerich, Dr., D-8000 München 40 (DE)

(56) Entgegenhaltungen:
- EP-A- 0 138 563
- GB-A- 2 198 285

## Beschreibung

Für schnelle integrierte Schaltkreise, wie sie in der Datentechnik, Konsumelektronik und Kommunikationstechnik erforderlich sind, werden Silizium-Bipolartransistoren benötigt.

Die Weiterentwicklung der Bipolartransistoren erfolgt zu höheren Geschwindigkeiten bei höherem Integrationsgrad. Um eine höhere Integration zu erreichen, wird an den einzelnen Transistor die Forderung gestellt, den Platzbedarf zu reduzieren.

Allgemein gebräuchlich ist derzeit der sogenannte PSA-(Poly-silicon-Selfaligned)-Transistor, der z. B. von W. M. Werner et al in "Modern Bipolar Technology for Gate Array and Memory Applications", Siemens Forschungs- und Entwicklungsbericht Band 17 (1988) Nr. 5 Seite 221 bis 226 beschrieben ist. Zur Herstellung des PSA-Transistors wird auf ein Siliziumsubstrat eine polykristalline Schicht aufgebracht. Die polykristalline Schicht ist mit einem ersten Leitfähigkeitstyp dotiert. Darauf wird eine erste Oxidschicht abgeschieden. In dieser Doppelschicht wird eine Fensterstruktur durch Ätzen bis auf die Substratoberfläche erzeugt, durch die die aktive Basis durch Implantation gebildet wird. Die Flanken des Fensters werden mit Oxidspacern bedeckt. Auf die Oxidschicht, die Flankenspacer und die freigelegte Oberfläche des Substrats wird sodann eine zweite polykristalline Schicht abgeschieden, die bezüglich der ersten polykristallinen Schicht vom entgegengesetzten Leitfähigkeitstyp ist. Durch Ausdiffusion aus der zweiten polykristallinen Schicht in das Substrat wird der Emitter selbstjustiert zur aktiven Basis gebildet. Die Definition der Ausmaße des Fensters und damit der Ausmaße der sich ergebenden Emitterweite erfolgt beim PSA-Transistor durch Photolithographie. Bei kleinen Emitterweiten wird die Abweichung von Sollmaßen sehr wahrscheinlich. Bei einer Ein-Mikrometer-Lithographie beträgt die effektive Emitterkontaktbreite etwa 0,6 µm, da die Flankenspacer eine endliche Ausdehnung haben. Bei einer Toleranz der Lithographie von mindestens +/- 0,1 µm pro Kante ist daher mit einer Toleranz von etwa 30 % der wirksamen Emitterweite zu rechnen. Für kleinere Emitterbreiten wird damit die Toleranz untragbar.

Schwankungen in der Größe der Emitterfläche wirken sich auf die Stromdichte im Transistor aus. Diese geht bei der Optimierung der Schaltungen bezüglich Strömen, Spannungshüben, Geschwindigkeit und Verlustleistung ein. Schwankungen in der Größenordnung von 30 % sind für viele Schaltungen nicht akzeptabel.

In Differenzverstärkern werden häufig Transistorpaare mit identischem Dotierungsprofil verwendet. Für solche Tranistorpaare hängt die Offsetspannung, d. h. die Steuerspannung, mit der die Eingänge eines Differenzverstärkers belegt werden müssen, damit die Ausgangsströme gleich groß werden, nur von den Unterschieden der wirksamen Emitterflächen ab. Für Offsetwerte von ungefähr 1 mV dürfen die Emitterflächen maximal um etwa 4 % differieren.

Aus der europäischen Patentanmeldung 0239825 A1 ist ein Bipolartransistor bekannt, bei dem die wirksamen Emitterweiten selbstjustiert, d. h. nicht über eine Photolithographie, definiert wird. Auf die Oberfläche eines Substrats, das eine stufenförmige Erhebung aufweist, wird eine leitfähige Schicht abgeschieden. Die Abscheidung erfolgt so, daß die Kante der stufenförmigen Erhebung gut bedeckt ist. Die Schicht wird dotiert. Durch anisotropes Rückätzen der Schicht wird an der senkrechten Flanke der stufenförmigen Erhöhung ein Ätzresiduum erzeugt. Durch Ausdiffusion aus diesem Ätzresiduum in das Substrat wird der Emitter gebildet. Das Ätzresiduum bildet einen Teil des Emitteranschlußgebietes. Die wirksame Emitterfläche ist in diesem Transistor definiert durch die gemeinsame Fläche von dem Substrat und des Ätzresiduums. Das Ausmaß dieser wirksamen Emitterfläche hängt damit von der Dicke der abgeschiedenen leitfähigen Schicht und den Parametern bei der Ätzung ab. Die Toleranz in der wirksamen Emitterfläche ist bei diesem Transistor reduziert auf etwa 10 %.

Aus EP-A-0 138 563 ist ein lateraler Bipolartransistor bekannt, der in der Siliziumschicht eines SOI-Substrats realisiert ist. Dabei liegen Emitter, Basis und Kollektor, welche durch Ionenimplantation gebildet werden, nebeneinander auf der isolierenden Schicht. Die Siliziumschicht ist so strukturiert, daß der laterale Bipolartransistor eine erhabene Struktur aus Silizium auf der isolierenden Schicht darstellt. Die Emitterweite ist durch die Dicke der Siliziumschicht bestimmt.

Die vorliegende Erfindung bezieht sich auf ein Verfahren gemäß Anspruch 1.

Bei diesem Verfahren wird eine Reduktion der Streuung der Emitterflächenmaße erzielt, und Emitterbreiten unter 0,5 µm können präzise eingestellt werden.

Die wirksame Emitterfläche in einem nach diesem Verfahren hergestellten Bipolartransistor ist die mit einer Siliziumstruktur bedeckte Flanke der ersten Siliziumschicht. Die Ausdehnung der wirksamen Emitterfläche ist damit durch die Dicke der Siliziumschicht definiert. Die Abscheidedicke der Siliziumschicht ist über das Kristallwachstum ausgezeichnet kontrollierbar. Die Siliziumschicht wird bevorzugt in einer Dicke zwischen 50 und 500 nm abgeschieden. Die Dicke der Siliziumschicht variiert im Bereich einer Chipabmessung nur im Promillebereich.

Es liegt im Rahmen der Erfindung, daß zwischen dem Substrat und der dotierten Siliziumschicht eine erste Isolationsschicht vorgesehen ist. Dadurch ist eine gute Kontrolle der Stromdichte im Transistor gegeben.

Durch Anordnung einer zweiten Isolationsschicht oberhalb der dotierten Siliziumschicht ist es möglich, die Kontaktierung der Basis oberhalb der Siliziumschicht vorzunehmen. Die Basis, die aus der dotierten Siliziumstruktur besteht, die die Flanke der Siliziumschicht bedeckt, wird durch einen Basisanschlußbereich aus einem elektrisch gut leitenden Material kontaktiert. Der Basisanschlußbereich ist auf der zweiten Isolationsschicht angeordnet und mit der die Basis bildenden Siliziumstruktur elektrisch verbunden. Auf dieser Weise ist eine niederohmige Kontaktierung der Basis gewährleistet. Der Basisanschlußbereich besteht z. B. aus einem Metallsilizid.

Es liegt im Rahmen der Erfindung, auf der dem Emitter abgewandten Seite der Basis den Kollektor als weitere dotierte Siliziumstruktur auf der Oberfläche des Substrats anzuordnen. Durch diese lineare Anordnung von Emitter, Basis, und Kollektor werden schnelle Schaltzeiten erreicht.

Zur Kontaktierung des Kollektors wird auf dem Kollektor ein Kollektoranschlußbereich angeordnet, der vom gleichen Leitfähigkeitstyp wie der Kollektor ist, der jedoch eine höhere Dotierung als der Kollektor aufweist. Dadurch ist eine niederohmige Kontaktierung des Kollektors gewährleistet.

Es liegt ferner im Rahmen der Erfindung, daß der Bipolartransistor Teil eines Bipolartransistorpaares ist. In diesem Fall weist die auf das Substrat aufgewachsene Silizumschicht zwei voneinander unabhängige Flanken auf, die jeweils parallel zur Oberflächennormalen ausgerichtet sind. An den Flanken ist jeweils eine Siliziumstruktur angeordnet. Dabei bildet die Siliziumschicht den gemeinsamen Emitter für beide Bipolartransistoren und die Siliziumstrukturen jeweils die Basis des jeweiligen Bipolartransistors. Im übrigen sind die beiden Bipolartransistoren identisch aufgebaut. Diese Schaltungsstruktur ist insbesondere für Differenzverstärker geeignet. Durch den gemeinsamen Emitter, der aus der Siliziumschicht gebildet wird, ist sichergestellt, daß die Emitterflächen der beiden Tranistoren identisch sind, was zu der besonders niedrigen Offsetspannung führt. Diese Schaltungsstruktur ist allgemein für jede Schaltung geeignet, die emittergekoppelte Bipolartransistoren enthält.

Weitere Ausgestaltungen der Erfindung gehen aus den übrigen Ansprüchen hervor.

Im folgenden wird die Erfindung anhand von Ausführungsbeispielen und den Figuren weiter erläutert.
- Fig. 1: zeigt einen Querschnitt eines erfindungsgemäß hergestellten Transistors.
- In Fig. 2: ist ein Querschnitt durch ein erfindungsgemäß hergestellten Transistorpaar dargestellt.
- In Fig. 3: ist die Schaltung eines erfindungsgemäß hergestellten Transistorpaares dargestellt.
- In Fig. 4: ist die Anschlußkonfiguration eines Transistorpaares dargestellt.

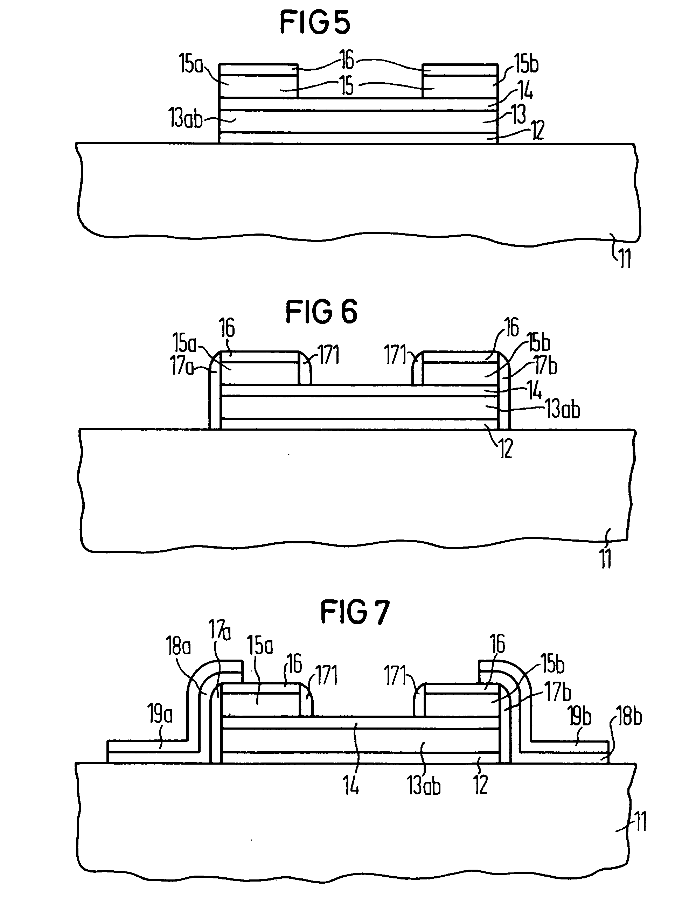

Anhand der Figuren 5 bis 9 wird die Schrittfolge des Herstellverfahrens erläutert.

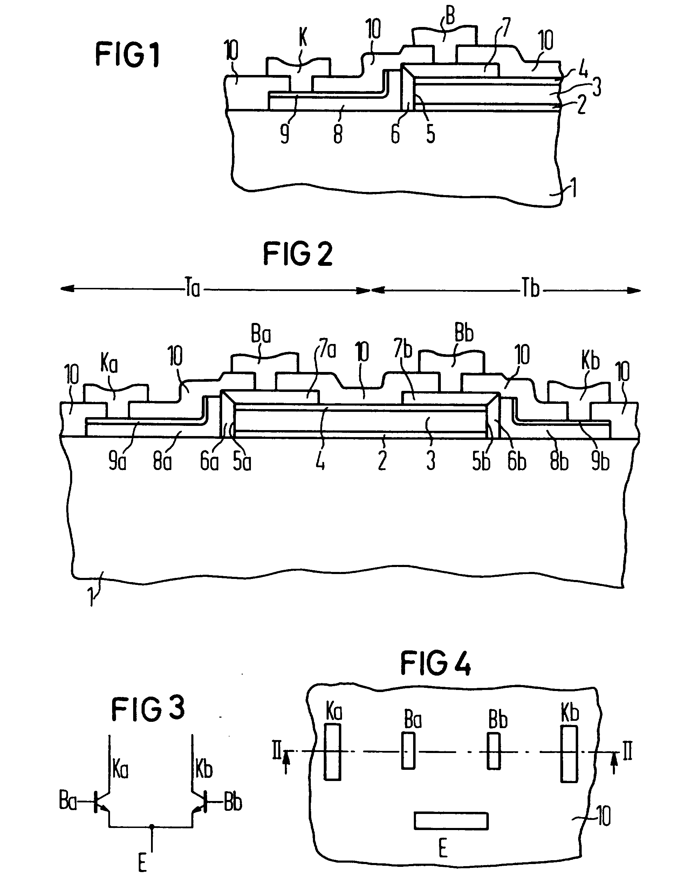

In Fig. 1 ist ein Substrat 1 aus Silizium dargestellt. Auf dem Substrat 1 ist eine erste Isolationsschicht 2 angeordnet. Die erste Isolationsschicht 2 besteht z. B. aus SiO₂ und ist in einer Dicke von z. B. 10 nm durch thermische Oxidation oder CVD (=Chemical Vapour Deposition) hergestellt. Auf der ersten Isolationsschicht 2 ist eine dotierte Siliziumschicht angeordnet. Die dotierte Siliziumschicht 3 ist z. B. n⁺-dotiert. Die Siliziumschicht 3 kann auf verschiedene Weise erzeugt werden:
a) Die Siliziumschicht 3 wird durch Abscheidung aus der Gasphase auf die Isolationsschicht 2 erzeugt (Polysiliziumtransistor).
b) Die Siliziumschicht 3 wird durch Abscheidung aus der Gasphase erzeugt, wobei anschließend eine epitaktische Rekristallisation der Schicht durchgeführt wird. Dabei wird gegebenenfalls ein Kontaktfenster zum Substrat 1 verwendet, um eine Keimzone (seeding zones) zur Verfügung zu haben.
c) Die Siliziumschicht 3 wird durch laterales epitaktisches Wachstum aus einer Keimzone heraus (lateral epitaxial overgrowth) erzeugt.
d) Die Siliziumschicht 3 kann auch nach dem sogenannten Waferbonding Verfahren, das z. B. aus Y. Arimoto et al, 46 th Device Research Conf., 1988, Boulder, Seite IA - 6 bekannt ist, erzeugt werden.
e) Zur Erzeugung der Siliziumschicht 3 sind im übrigen alle anderen sogenannten 501 (Silicon on Insulator)-Techniken anwendbar, die eine monokristalline Siliziumschicht auf einem Isolator liefern, wie z. B. SIMOX und FIPOS, die z. B. in dem Artikel von J. Heisma, 18th ESSDERC, Conf. Proc., Journal de Physique, Colloque C4, Supplement Nr. 9, Seite C4-3 beschrieben sind.

Anschließend wird die Siliziumschicht 3 mit 10¹⁶ cm⁻² Arsen implantiert. Sie weist z. B. eine Dicke zwischen 50 und 500 nm auf. Auf der dotierten Siliziumschicht 3 ist eine zweite Isolationsschicht 4 angeordnet. Die zweite Isolationsschicht 4 besteht z. B. aus Siliziumoxid und wird in einer Dicke von z. B. 100 nm durch CVD hergestellt. Die erste Isolationsschicht 2, die dotierte Siliziumschicht 3 und die zweite Isolationsschicht 4 weisen eine gemeinsame senkrecht zur Schichtfolge ausgerichtete Flanke 5 auf. Die Flanke 5 verläuft parallel zur Oberflächennormalen der dotierten Siliziumschicht 3. Die Flanke 5 ist von einer dotierten Siliziumstruktur 6 bedeckt. Die dotierte Siliziumstruktur 6 ist vom entgegengesetzten Leitfähigkeitstyp wie die dotierte Siliziumschicht 3, d. h. z. B. p-dotiert. Die Dotierung der dotierten Siliziumstruktur 6 erfolgt z. B. durch Bor. Die dotierte Siliziumstruktur 6 weist eine Dicke von etwa 10 bis 100 nm auf. Die dotierte Siliziumschicht 3 bildet den Emitter des Bipolartransistors. Die dotierte Siliziumstruktur 6 bildet die Basis des Bipolartransistors. Die dotierte Siliziumstruktur 6 wird durch eine leitfähige Schicht 7 kontaktiert. Die leitfähige Schicht 7 stellt den Anschlußbereich für die dotierte Siliziumstruktur 6, die die Basis bildet, dar. Die leitfähige Schicht 7 besteht z. B. aus einer hochdotierten Siliziumschicht vom gleichen Leitfähigkeitstyp wie die dotierte Siliziumstruktur 6, jedoch mit höherer Leitfähigkeit, oder aus einem Metallsilizid. Die leitfähige Schicht 7 hat eine Dicke von z. B. 200 nm.

An der der Flanke 5 abgewandten Oberfläche der dotierten Siliziumstruktur 6 ist eine weitere dotierte Siliziumschicht 8 angeordnet. Sie ist vom gleichen Leitfähigkeitstyp wie die dotierte Siliziumschicht 3, d. h. z. B. n-dotiert. Die weitere dotierte Siliziumschicht 8 bildet den Kollektor des Transistors. Auf der weiteren dotierten Siliziumschicht 8 ist eine Anschlußschicht 9 angeordnet. Die Anschlußschicht 9 ist vom gleichen Leitfähigkeitstyp wie die weitere dotierte Siliziumschicht 8, sie weist jedoch höhere Leitfähigkeit auf. Alle freiliegenden Bereiche des Transistors und des Substrats 1 sind mit einer Passivierungsschicht 10 bedeckt, die z. B. 100 bis 200 nm dick ist und aus CVD-Oxid besteht. In der Passivierungsschicht 10 sind Kontaktlöcher zur Kontaktierung des Emitters (nicht dargestellt), der Basis und des Kollektors vorgesehen. Die Kontaktlöcher sind mit Metallisierungen aus z. B. PtSi/TiW/AlSiTi aufgefüllt, die den Emitterkontakt (nicht dargestellt), den Basiskontakt B und den Kollektorkontakt K bilden. Der Emitterkontakt ist in einer Ebene parallel zu dem gezeigten Schnitt angeordnet.

In Fig. 2 sind zwei erfindungsgemäße Transistoren dargestellt, die ein Transistorpaar bilden. Auf dem Substrat 1 ist die erste Isolationsschicht 2 aus z. B. SiO₂ angeordnet. Auf der ersten Isolationsschicht 2 ist die dotierte Siliziumschicht 3 angeordnet. Auf der dotierten Siliziumschicht 3 ist die zweite Isolationsschicht 4 angeordnet. Die dotierte Siliziumschicht 3 bildet den Emitter für beide Transistoren. Die erste Isolationsschicht 2, die dotierte Siliziumschicht 3 und die zweite Isolationsschicht 4 weisen gegenüberliegende Flanken 5a und 5b auf. Die Flanken 5a, 5b sind mit dotierten Siliziumstrukturen 6a, 6b bedeckt. Die dotierten Siliziumstrukturen 6a, 6b bilden jeweils die Basis des jeweiligen Transistors. Die dotierten Siliziumstrukturen 6a, 6b werden durch leitfähige Schichten 7a, 7b, die auf der zweiten Isolationsschicht 4 angeordnet sind, kontaktiert. Die leitfähigen Schichten 7a, 7b bilden die Basisanschlußgebiete der beiden Transistoren. An den den Flanken 5a, 5b abgewandten Oberflächen der dotierten Siliziumstrukturen 6a, 6b sind weitere dotierte Siliziumschichten 8a, 8b angeordnet, die vom gleichen Leitfähigkeitstyp sind wie die dotierte Siliziumschicht 3. Die weiteren dotierten Siliziumschichten 8a, 8b bilden die Kollektoren der jeweiligen Transistoren. Auf den weiteren dotierten Siliziumschichten 8a, 8b sind Anschlußschichten 9a, 9b angeordnet. Die Anschlußschichten 9a, 9b sind vom gleichen Leitfähigkeitstyp wie die weiteren dotierten Siliziumschichten 8a, 8b, sie weisen jedoch eine höhere Leitfähigkeit auf. Die gesamte Struktur ist mit der Passivierungsschicht 10 bedeckt. In der Passivierungsschicht 10 sind mit Metallisierungen versehene Kontaktlöcher angeordnet für die Basiskontakte Ba, Bb sowie die Kollektorkontakte Ka, Kb des jeweiligen Transistors. Mit Hilfe von Doppelpfeilen sind die Bereiche der jeweiligen Transistoren Ta, Tb angedeutet. Die einzelnen Transistoren Ta, Tb sind genauso aufgebaut, wie der anhand von Fig. 1 geschilderte Transistor. Der gemeinsame Emitter der Transistoren Ta, Tb wird über einen gemeinsame Emitterkontakt kontaktiert, der außerhalb des in Fig. 2 dargestellten Schnittes liegt.

In Fig. 3 ist ein Schaltbild für das anhand von Fig. 2 erläuterte Transistorpaar dargestellt. Die beiden Transistoren haben jeweils einen Basiskontakt Ba, Bb und einen Kollektorkontakt Ka, Kb. Sie haben jedoch nur einen gemeinsamen Emitterkontakt E.

In Fig. 4 ist eine Draufsicht auf die in Fig. 2 dargestellte Struktur dargestellt. Auf der Passivierungsschicht 10 sind die Kollektorkontakte Ka, Kb, die Basiskontakte Ba, Bb und der gemeinsame Emitterkontakt E angeordnet. Dieser Kontaktanordnung ist Anschlußkonfigurationen, wie sie in ECL- bzw. CML-Schaltungen auftreten, gut angepaßt. Daher kann mit einem erfindungsgemäßen Transistorpaar der Platzbedarf in diesen Schaltungen reduziert werden. Die Leitungsführung in diesen Schaltungen vereinfacht sich.

Im folgenden wird ein Herstellverfahren für erfindungsgemäße Transistoren beschrieben.

Die in Fig. 5 dargestellte Struktur wurde durch folgende Verfahrensschritte erzeugt: Auf ein Siliziumsubstrat 11 wird eine erste Isolationsschicht 12 abgeschieden. Die erste Isolationsschicht 12 ist z. B. 10 nm dick, sie besteht z. B. aus SiO₂ und sie wird z. B. durch thermische Oxidation oder durch CVD (Chemical Vapour Deposition) erzeugt. Auf der ersten Isolationsschicht 12 wird anschließend eine dotierte Siliziumschicht 13 mit Hilfe eines Kristallwachstumsverfahrens hergestellt. Über das Kristallwachstum läßt sich die Abscheidedicke der dotierten Siliziumschicht 13 in einem Bereich zwischen 20 nm und 500 nm auf kleiner/gleich 1 nm genau kontrollieren. Die dotierte Siliziumschicht 13 wird z. B. durch CVD-Siliziumabscheidung in einer Dicke von 200 bis 500 nm hergestellt. Nach der Abscheidung erfolgt eine Implantation mit z. B. 10¹⁶ cm⁻² Arsen. Dadurch ist die dotierte Siliziumschicht 13 n⁺-dotiert. Auf die dotierte Siliziumschicht 13 wird eine zweite Isolationsschicht 14 abgeschieden. Die zweite Isolationsschicht 14 ist z. B. 100 nm dick, besteht z. B. aus Siliziumoxid und wird z. B. durch CVD erzeugt. Auf die zweite Isolationsschicht 14 wird eine leitfähige Schicht 15 aufgebracht. Die leitfähige Schicht 15 besteht z. B. aus 200 nm dickem CVD-Silizium, das durch Implantation von Bor p⁺-dotiert wird. Auf der leitfähigen Schicht 15 wird z. B. durch CVD eine dritte Isolationsschicht 16 aus z. B. Siliziumoxid in einer Dicke von z. B. 100 nm erzeugt.

Nach der Herstellung dieser Mehrfachschicht werden durch eine erste Phototechnik die Basisanschlußbereiche 15a, 15b definiert und durch Ätzung der dritten Isolationsschicht 16 und der leitfähigen Schicht 15 hergestellt.

Anschließend wird durch eine zweite Phototechnik der Emitterbereich 13ab definiert und durch die Ätzung der zweiten Isolationsschicht 14, der dotierten Siliziumschicht 13 und der ersten Isolationsschicht 12 erzeugt.

Im folgenden Schritt wird die Oberfläche der sich ergebenden Struktur mit einer dotierten Siliziumschicht, die zur dotierten Siliziumschicht 13 die entgegengesetzte Leitfähigkeit aufweist, versehen. Dies erfolgt entweder durch Abscheidung einer undotierten Siliziumschicht in einer Dicke von z. B. 10 bis 100 nm und anschließender Borimplantation oder durch p-dotierte Abscheidung der Siliziumschicht. Durch anschließende anisotrope Rückätzung dieser Schicht werden äußere Flankenbedeckungen 17a, 17b an den äußeren Flanken der Basisanschlußbereiche 15a, 15b und des Emitterbereichs 13ab sowie innere Flankenbedeckungen 171 an den inneren Flanken der Basisanschlußbereiche 15a, 15b erzeugt (s. Fig. 6). Die äußeren Flankenbedeckungen 17a, 17b bilden die Basisbereiche. Die inneren Flankenbedeckungen 171 sind herstellungsbedingt und haben keine Funktion.

Im folgenden wird die sich ergebende Struktur ganzflächig mit einer weiteren dotierten Siliziumschicht versehen, die vom gleichen Leitfähigkeitstyp wie die dotierte Siliziumschicht 13 ist. Darauf wird eine zweite weitere Siliziumschicht abgeschieden vom gleichen Leitfähigkeitstyp jedoch von höherer Leitfähigkeit ist. Die beiden Schichten sind z. B. beide 100 nm dick, die erste n-dotiert und die zweite n⁺-dotiert. Durch eine dritte Phototechnik werden die Kollektorbereiche 18a, 18b definiert und durch Ätzung der beiden Schichten werden die Kollektorbereiche 18a, 18b sowie die Kollektoranschlußbereiche 19a, 19b hergestellt (s. Fig. 7).

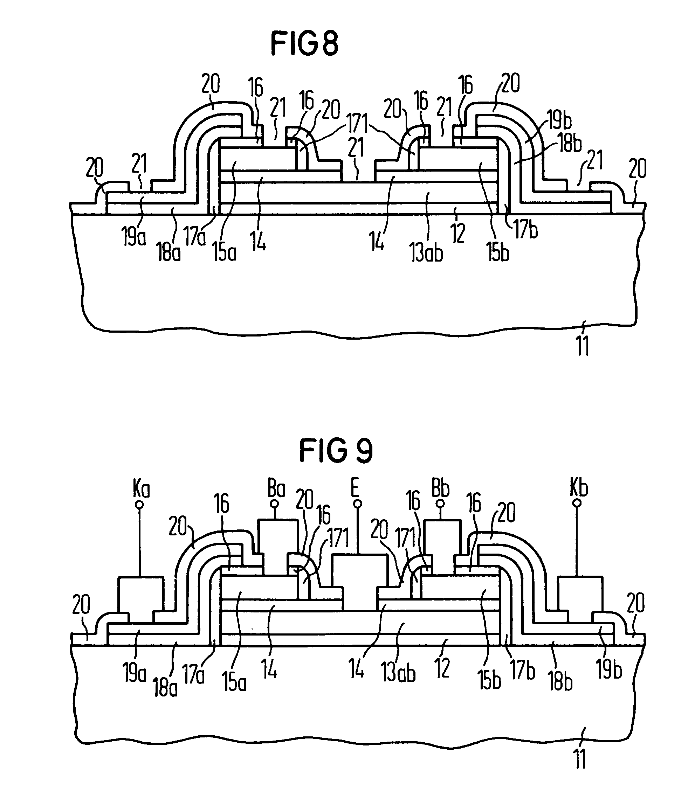

Die Oberfläche der sich ergebenden Struktur wird mit einer Passivierungsschicht 20 bedeckt. Die Passivierungsschicht 20 ist z. B. 100 bis 200 nm dick und besteht aus CVD-Oxid. In Fig. 8 ist die Struktur dargestellt, nachdem in der Passivierungsschicht 20 Kontaktlöcher 21 geöffnet wurden, die auf die Kollektoranschlußbereiche 19a, 19b, auf die Basisanschlußbereiche 15a, 15b und auf den Emitterbereich 13ab führen.

Durch Auffüllen der Kontaktlöcher 21 mit Metallisierungen aus z. B. PtSi/TiW/AlSiTi, wird das Bipolartransistorpaar mit Kollektorkontakten Ka, Kb, mit Basiskontakten Ba, Bb und einem gemeinsamen Emitterkontakt E versehen und fertiggestellt (s. Fig. 9).

Das Transistorpaar besteht aus zwei lateralen Bipolartransistoren, die aus dem Emitterbereich 13ab, dem Basisbereich 17a, dem Kollektorbereich 18a bzw. dem Emitterbereich 13ab, dem Basisbereich 17b und dem Kollektorbereich 18b gebildet werden. Die wirksamen Emitterweiten sind durch die Kontaktflächen des Emitterbereichs 13ab mit dem Basisbereich 17a bzw. 17b definiert. Da der Emitterbereich 13ab durch Kristallwachstum der dotierten Siliziumschicht erzeugt wurde, sind die Emitterweiten durch die Schichtdicke der dotierten Siliziumschicht 13 definiert. Die Schichtdicke der dotierten Siliziumschicht 13 ist über das Kristallwachstum gut kontrollierbar, wie bereits oben beschrieben.

Die Herstellung eines einzelnen Bipolartransistors gemäß der Erfindung erfolgt analog der Beschreibung für ein Transistorpaar.

## Patentansprüche

1. Verfahren zur Herstellung einer integrierten Schaltungsstruktur mit mindestens einem lateralen Bipolartransistor mit einem Emitterbereich (3, 13ab), einem Basisbereich (6, 17a) und einem Kollektorbereich (8, 18a), mit folgenden Schritten:
- auf einem Substrat (1, 2, 11, 12) wird eine erste Siliziumschicht (3, 13), die von einem ersten Leitfähigkeitstyp dotiert ist, erzeugt, die so strukturiert wird, daß sie mindestens eine zur Oberflächennormalen parallele Flanke (5) aufweist und den Emitterbereich (3, 13ab) des Bipolartransistors bildet,
- ganzflächig wird eine zweite Siliziumschicht abgeschieden und dotiert, die von einem zweiten, zum ersten entgegengesetzten Leitfähigkeitstyp dotiert ist und die Flanke der ersten Siliziumschicht (3, 13) bedeckt,
- die zweite Siliziumschicht wird durch anisotropes Rückätzen so weit entfernt, daß an der zur Oberflächennormalen parallen Flanke eine Flankenbedeckung entsteht, die den Basisbereich (6, 17a) des Bipolartransistors bildet,
- durch Abscheiden und Strukturieren einer dotierten, dritten Siliziumschicht, die vom ersten Leitfähigkeitstyp dotiert ist, wird der Kollektorbereich (8, 18a) des Bipolartransistors gebildet, der auf der dem Emitterbereich (3, 13ab) abgewandten Seite des Basisbereichs (6, 17a) auf der Oberfläche des Substrats (11, 12) angeordnet ist.

2. Verfahren nach Anspruch 1,
bei dem auf einen Silizium-Halbleiterkörper (11) eine erste Isolationsschicht (12) aufgebracht wird, wobei das Substrat (11, 12) vor dem Aufwachsen der ersten Siliziumschicht (13) erzeugt wird,
bei dem die erste Siliziumschicht (13) auf die erste Isolationsschicht (12) aufgewachsen wird,
bei dem auf die erste Siliziumschicht (13) eine zweite Isolationsschicht (14) aufgebracht wird,
bei dem auf die zweite Isolationsschicht (14) eine leitfähige Schicht (15) aufgewachsen wird,
bei dem auf die leitfähige Schicht (15) eine dritte Isolationsschicht (16) aufgebracht wird,
bei dem durch eine erste Phototechnik ein Basisanschlußbereich (15a) des Bipolartransistors definiert und durch Abätzen der dritten Isolationsschicht (16) und der leitfähigen Schicht (15) so hergestellt wird, daß er mindestens eine zur Oberflächennormalen parallele Flanke aufweist,
bei dem durch eine zweite Phototechnik der Emitterbereich (13ab) durch Abätzen der zweiten Isolationsschicht (14), der ersten Siliziumschicht (13) und der ersten Isolationsschicht (12) hergestellt wird, wobei die Flanke der ersten Siliziumschicht (13) gebildet wird,
bei dem ganzflächig die zweite Siliziumschicht abgeschieden wird,
bei dem beim anisotropen Rückätzen zur Bildung des Basisbereichs (17a) die Oberfläche des Substrats (11), der dritten Isolationsschicht (16) und der zweiten Isolationsschicht (14) so freigelegt wird, daß der Basisbereich (17a) die Flanke des Basisanschlußbereichs (15a) und des Emitterbereichs (13ab) als Flankenbedeckung bedeckt,
bei dem die dritte Siliziumschicht ganzflächig abgeschieden wird, und
bei dem durch eine dritte Phototechnik der Kollektorbereich (18a) definiert wird.

3. Verfahren nach Anspruch 2,
bei dem auf die dritte dotierte Siliziumschicht eine dotierte, vierte Siliziumschicht abgeschieden wird, die vom gleichen Leitfähigkeitstyp wie die dritte Siliziumschicht ist, jedoch eine höhere Leitfähigkeit aufweist,
bei dem die dritte Siliziumschicht und die vierte Siliziumschicht nach der dritten Phototechnik durch Wegätzen gemeinsam strukturiert werden, so daß der Kollektorbereich (18a) und ein Kollektoranschlußgebiet (19a) des Bipolartransistors entstehen,
bei dem die Struktur mit einer Passivierungsschicht (20) versehen wird, und
bei dem in der Passivierungsschicht (20) Kontaktlöcher zu dem Kollektoranschlußgebiet (19a), zu dem Basisanschlußbereich (15a) und zu dem Emitterbereich (13ab) geöffnet und mit Metallisierungen versehen werden.

4. Verfahren nach Anspruch 2 oder 3,
bei dem die erste Siliziumschicht (13) durch CVD-Siliziumabscheidung in einer Dicke von 50 bis 500 nm und anschließende Implantation von 10¹⁶ cm⁻² Arsen erzeugt wird.

5. Verfahren nach einem der Ansprüche 2 bis 4,
bei dem die zweite Siliziumschicht in einer Dicke von 10 bis 100 nm als undotierte Siliziumschicht erzeugt wird, die anschließend durch Borimplantation dotiert wird.

6. Verfahren nach einem der Ansprüche 1 bis 5,
bei dem die erste Siliziumschicht (3, 13) so strukturiert wird, daß sie zwei voneinander unabhängige Flanken (5a, 5b) aufweist, die jeweils parallel zu Oberflächennormalen ausgerichtet sind, und daß sie den gemeinsamen Emitterbereich (3, 13ab) identisch aufgebauter Bipolartransistoren eines Bipolartransistorpaares bildet,
bei dem beim anisotropen Rückätzen der zweiten Siliziumschicht an den beiden Flanken (5a, 5b) jeweils eine Flankenbedeckung entsteht, die jeweils den Basisbereich (6a, 6b, 17a, 17b) eines Bipolartransistors des Bipolartransistorpaares bildet, und
bei dem die dritte Siliziumschicht so strukturiert wird, daß ein Kollektorbereich (8a, 8b, 18a, 18b) für den jeweiligen Bipolartransistor des Bipolartransistorpaares gebildet wird, der jeweils auf der dem Emitterbereich (3, 13ab) abgewandten Seite des jeweiligen Basisbereichs (6a, 6b, 17a, 17b) auf der Oberfläche des Substrats (1, 2, 11, 12) angeordnet ist.

## Claims

1. Method for producing an integrated circuit structure having at least one lateral bipolar transistor having an emitter region (3, 13ab), a base region (6, 17a) and a collector region (8, 18a), having the following steps:
- a first silicon layer (3, 13), which is doped by a first conductivity type, is produced on a substrate (1, 2, 11, 12) and is structured in such a way that it has at least one flank (5) parallel to the normal to the surface and forms the emitter region (3, 13ab) of the bipolar transistor,
- a second silicon layer is deposited over the whole area and doped, which layer is doped by a second conductivity type opposite to the first and covers the flank of the first silicon layer (3, 13),
- the second silicon layer is removed by anisotropic etching back until a flank covering, which forms the base region (6, 17a) of the bipolar transistor, is produced on the flank which is parallel to the normal to the surface,
- the collector region (8, 18a) of the bipolar transistor is formed by deposition and structuring of a doped, third silicon layer, which is doped by the first conductivity type, which collector region is arranged on the surface of the substrate (11, 12) on that side of the base region (6, 17a) which faces away from the emitter region (3, 13ab).

2. Method according to Claim 1,
in which a first insulation layer (12) is applied to a silicon semiconductor body (11), the substrate (11, 12) being produced before the first silicon layer (13) is grown on,
in which the first silicon layer (13) is grown onto the first insulation layer (12),
in which a second insulation layer (14) is applied to the first silicon layer (13),
in which a conductive layer (15) is grown onto the second insulation layer (14),
in which a third insulation layer (16) is applied to the conductive layer (15),
in which, by means of a first photographic technique, a base terminal region (15a) of the bipolar transistor is defined and is produced by etching away the third insulation layer (16) and the conductive layer (15) such that it has at least one flank parallel to the normal to the surface,
in which, by means of a second photographic technique, the emitter region (13ab) is produced by etching away the second insulation layer (14), the first silicon layer (13) and the first insulation layer (12), the flank of the first silicon layer (13) being formed,
in which the second silicon layer is deposited over the whole area,
in which, during anisotropic etching back for the purpose of forming the base region (17a), the surface of the substrate (11), of the third insulation layer (16) and of the second insulation layer (14) is exposed in such a way that the base region (17a) covers the flank of the base terminal region (15a) and of the emitter region (13ab) as a flank covering,
in which the third silicon layer is deposited over the whole area, and
in which the collector region (18a) is defined by means of a third photographic technique.

3. Method according to Claim 2,
in which a doped, fourth silicon layer, which is of the same conductivity type as the third silicon layer but has a higher conductivity, is deposited on the third doped silicon layer,
in which, after the third photographic technique, the third silicon layer and the fourth silicon layer are jointly structured by etching away, with the result that the collector region (18a) and a collector terminal region (19a) of the bipolar transistor are produced,
in which the structure is provided with a passivation layer (20), and
in which contact holes to the collector terminal region (19a), to the base terminal region (15a) and to the emitter region (13ab) are opened in the passivation layer (20) and are provided with metallization layers.

4. Method according to Claim 2 or 3,
in which the first silicon layer (13) is produced by CVD silicon deposition to a thickness of 50 to 500 nm and subsequent implantation of 10¹⁶ cm⁻² of arsenic.

5. Method according to one of Claims 2 to 4,
in which the second silicon layer is produced to a thickness of 10 to 100 nm as an undoped silicon layer which is subsequently doped by means of boron implantation.

6. Method according to one of Claims 1 to 5,
in which the first silicon layer (3, 13) is structured in such a way that it has two mutually independent flanks (5a, 5b) which are each aligned parallel to normals to the surface, and that it forms the common emitter region (3, 13ab) of identically constructed bipolar transistors of a pair of bipolar transistors,
in which, during anisotropic etching back of the second silicon layer, a flank covering is produced on each of the two flanks (5a, 5b), which flank covering respectively forms the base region (6a, 6b, 17a, 17b) of a bipolar transistor of the pair of bipolar transistors, and
in which the third silicon layer is structured in such a way that a collector region (8a, 8b, 18a, 18b) is formed for the respective bipolar transistor of the pair of bipolar transistors, which collector region is in each case arranged on the surface of the substrate (1, 2, 11, 12) on that side of the respective base region (6a, 6b, 17a, 17b) which faces away from the emitter region (3, 13ab).

## Revendications

1. Méthode de fabrication d'un circuit intégré comprenant au moins un transistor bipolaire latéral avec une zone d'émetteur (3, 13ab), une zone de base (6, 17a) et une zone de collecteur (8, 18a), selon les phases suivantes :
- sur un substrat (1, 2, 11, 12) est réalisée une première couche de silicium (3 , 13) dopée d'un premier type de conductivité, qui est structurée de manière à présenter au moins un flanc (5) parallèle à la normale à la surface et à former la zone d'émetteur (3, 13ab) du transistor bipolaire,
- sur toute la surface est déposée une deuxième couche de silicium dopée d'un deuxième type de conductivité opposé au premier et le flanc de la première couche de silicium (3, 13) est recouvert,
- la deuxième couche de silicium est supprimée par gravure en retrait anisotrope jusqu'à obtenir au flanc parallèle à la normale à la surface un recouvrement de flanc qui forme la zone de base (6, 17a) d'un transistor bipolaire,
- par dépôt et structuration d'une troisième couche de silicium dopée du premier type de conductivité est formée la zone de collecteur (8, 18a) du transistor bipolaire, qui est disposée sur le côté opposé à la zone d'émetteur (3, 13ab) de la zone de base (6, 17a), sur la surface du substrat (11, 12).

2. Méthode selon la revendication 1,
selon laquelle une première couche isolante (12) est placée sur un corps semi-conducteur de silicium (11), le substrat (11, 12) étant réalisé avant le dépôt de la première couche de silicium (13),
selon laquelle la première couche de silicium (13) est déposée sur la première couche isolante (12),
selon laquelle une deuxième couche isolante (14) est placée sur la première couche de silicium (13),
selon laquelle une couche conductrice (15) est déposée sur la deuxième couche isolante (14),
selon laquelle une troisième couche isolante (16) est placée sur la couche conductrice (15),
selon laquelle une zone de connexion de base (15a) du transistor bipolaire est définie à l'aide d'une première technique photographique et réalisée par gravure en retrait de la troisième couche isolante (16) et de la couche conductrice (15) de façon à présenter au moins un flanc parallèle à la normale à la surface,
selon laquelle la zone d'émetteur (13ab) est réalisée à l'aide d'une deuxième technique photographique, par gravure de la deuxième couche isolante (14), de la première couche de silicium (13) et de la première couche isolante (12), ce par quoi le flanc de la première couche de silicium (13) est formé,
selon laquelle la deuxième couche de silicium est déposée sur toute la surface,
selon laquelle, lors de la gravure en retrait anisotrope pour former la zone de base (17a), la surface du substrat (11), de la troisième couche isolante (16) et de la deuxième couche isolante (14) est dégagée de façon à ce que la zone de base (17a) recouvre le flanc de la zone de connexion de base (15a) et de la zone d'émetteur (13ab), sous forme de recouvrement de flanc,
selon laquelle la troisième couche de silicium est déposée sur toute la surface, et
selon laquelle la zone de collecteur (18a) est définie à l'aide d'une troisième technique photographique.

3. Méthode selon la revendication 2,
selon laquelle une quatrième couche de silicium dopée est déposée sur la troisième couche de silicium dopée, qui est du même type de conductivité que la troisième couche de silicium, mais qui présente une conductivité plus élevée,
selon laquelle la troisième couche de silicium et la quatrième couche de silicium sont structurées ensemble selon la troisième technique photographique par gravure, de manière à obtenir la zone de collecteur (18a) et une zone de connexion de collecteur (19a) du transistor bipolaire,
selon laquelle la structure est pourvue d'une couche de passivation (20), et
selon laquelle des trous de contact assurant le contact avec la zone de connexion de collecteur (19a), avec la zone de connexion de base (15a) et avec la zone d'émetteur (13ab) sont ménagés dans la couche de passivation (20) et pourvus d'éléments métalliques.

4. Méthode selon la revendication 2 ou 3,
selon laquelle la première couche de silicium (13) est obtenue par dépôt de silicium CVD d'une épaisseur de 50 à 500 nm, suivi d'une implantation d'arsenic de 10¹⁶ cm⁻².

5. Méthode selon l'une des revendications 2 à 4,
selon laquelle la deuxième couche de silicium est obtenue sous forme de couche de silicium non dopée d'une épaisseur de 10 à 100 nm, qui est ensuite dopée par implantation de bore.

6. Méthode selon l'une des revendications 1 à 5,
selon laquelle la première couche de silicium (3, 13) est structurée de manière à présenter deux flancs (5a, 5b) indépendants l'un de l'autre, qui sont disposés chacun parallèlement à la normale à la surface, et à former la zone d'émetteur (3, 13ab) commune de transistors bipolaires de construction identique d'une paire de transistors,
selon laquelle, lors de la gravure en retrait anisotrope de la deuxième couche de silicium, respectivement un recouvrement de flanc est obtenu aux deux flancs (5a, 5b), qui forme à chaque fois la zone de base (6a, 6b, 17a, 17b) d'un transistor bipolaire de la paire de transistors, et
selon laquelle la troisième couche de silicium est structurée de manière à former une zone de collecteur (8a, 8b, 18a, 18b) pour le transistor bipolaire respectif de la paire de transistors bipolaires, qui est disposée à chaque fois sur le côté opposé à la zone d'émetteur (3, 13ab) de la zone de base (6a, 6b, 17a, 17b) respective, sur la surface du substrat (1, 2, 11, 12).
